# EUROPEAN PATENT SPECIFICATION

(11) **EP 3 179 839 B1**
(45) Date of publication and mention of the grant of the patent: **23.09.2020**
(21) Application number: 14899108.6
(22) Date of filing: 08.08.2014
(51) Int. Cl.: H05K 13/04, H05K 13/08

(54) **SUBSTRATE PRODUCTION METHOD AND SUBSTRATE PRODUCTION CONDITION DETERMINATION METHOD**
SUBSTRATHERSTELLUNGSVERFAHREN UND BESTIMMUNGSVERFAHREN EINES SUBSTRATHERSTELLUNGSZUSTANDS
PROCÉDÉ DE PRODUCTION DE SUBSTRAT ET PROCÉDÉ DE DÉTERMINATION D'ÉTAT/D'ÉTATS DE PRODUCTION DE SUBSTRAT

(43) Date of publication of application: 14.06.2017
(73) Proprietor: FUJI Corporation, Chiryu Aichi (JP)
(72) Inventor: YASUI Yoshihiro, Chiryu Aichi (JP); ASAOKA Tetsuya, Chiryu Aichi (JP); KONDO Kikuo, Chiryu Aichi (JP)
(74) Representative: Grünecker Patent- und Rechtsanwälte PartG mbB
(86) International application number: PCT/JP2014/071001
(87) International publication number: WO 2016/021042

(56) References cited:
- EP-A1- 0 478 360
- WO-A1-2009/060705
- JP-A- 2001 168 578
- JP-A- 2001 313 492
- JP-A- 2004 228 251
- JP-A- 2007 142 216
- JP-A- 2008 004 761
- JP-A- 2010 021 531

## Description

### Technical Field

The present invention relates to a board production method and a board production condition determination method.

### Background Art

There is known a component mounting system in which a plurality of component mounting machines which are provided with two conveyance lanes are disposed in series in order to mount multiple electronic components onto a printed circuit board. PTL 1 describes, as a component mounting machine which is provided with two conveyance lanes, a first component mounting machine which is provided with two mounting heads and component supply sections on both sides, and a second component mounting machine which is provided with a single mounting head and a component supply section on one side only.

In the first component mounting machine which is provided with the two mounting heads and the component supply sections on both sides, production using a first conveyance lane and one of the mounting heads, and production using a second conveyance lane and the other mounting head are independently carried out. In general, the production system is referred to as an independent production system. In the independent production system, a worker is capable of performing a disposition changing process of components in one of the component supply sections during other production. However, when the worker performs the disposition changing process of the components, one of the two mounting heads always stops. Therefore, a board conveyance time is included in the cycle time, and cycle time becomes longer.

Meanwhile, the second component mounting machine which is provided with a single mounting head and a component supply section of only one side generally alternately performs mounting of components onto the printed circuit board which is conveyed in the first conveyance lane, and mounting of components onto the printed circuit board which is conveyed in the second conveyance lane. In general, the production system is referred to as a dual production system. In the dual production system, when conveying the printed circuit board in the first conveyance lane, the mounting head is capable of performing mounting of components onto a printed circuit board which is disposed in the second conveyance lane. Therefore, the board conveyance time is not included in the cycle time. However, in a case in which the nozzles which are used in the mounting onto the printed circuit board which is conveyed in the first conveyance lane and the nozzles which are used in the mounting onto the printed circuit board which is conveyed in the second conveyance lane are different, it becomes necessary to exchange the nozzles. Therefore, the cycle time becomes longer by an amount corresponding to the exchanging time of the nozzles.

Therefore, in PTL 1, in each component mounting machine, it is determined as to which component supply section in which component mounting machine the disposal of each of the components is to be performed so as to increase the commonality between the nozzles which are used in the mounting onto the printed circuit board which is conveyed in the first conveyance lane and the nozzles which are used in the mounting onto the printed circuit board which is conveyed in the second conveyance lane.
Further related background art is disclosed in PTL 2 und PTL 3.

### Citation List

### Patent Literature

PTL 1: JP-A-2010-21531
PTL 2: JP 2001 313492 A
PTL 3: EP 0 478 360 A1

### Summary of Invention

### Technical Problem

Here, in the dual production system described in PTL 1, a board type to be conveyed in the first conveyance lane is different from the board type to be conveyed in the second conveyance lane. The calculation of the commonality of the nozzles targets a case in which the printed circuit boards are conveyed in the conveyance lanes, one type at a time. Therefore, the commonality of the nozzles relates to the two types of printed circuit board which are to be conveyed in both conveyance lanes.

However, depending on the production plan, there is a case in which there is a demand to produce three or more types of printed circuit board. For example, there is a case in which a worker wishes to alternately convey a plurality of types of printed circuit board to the first conveyance lane. There is a case in which the worker wishes to convey the same type of printed circuit board in two conveyance lanes . In this manner, there is a demand for an increase in the degree of freedom of the conveyance.

In such a case, as described in PTL 1, simply increasing the commonality between the nozzles which are used in the mounting onto the printed circuit board which is conveyed in the first conveyance lane and the nozzles which are used in the mounting onto the printed circuit board which is conveyed in the second conveyance lane is not sufficient.

An object of the present invention is to provide a board production method and a board production condition determination method which are capable of further shortening a cycle time in a case in which a component mounting machine which is provided with a single mounting head is used.

### Solution to Problem

### (Board Production Method)

A board production method according to the invention is a board production method which uses a plurality of component mounting machines which are disposed in series to perform continuous production of a plurality of types of printed circuit board. Each of the plurality of component mounting machines includes a plurality of conveyance lanes which convey the plurality of types of printed circuit board, a component supply section which includes a component disposition region in which a plurality of types of component group are disposed, and a single mounting head to which at least one or more nozzles are attached and which mounts the plurality of types of component group which are supplied from the component supply section onto the printed circuit board which is conveyed in the conveyance lanes.

The board production method includes a condition determination step of determining a disposition of the nozzles in each of the mounting heads and a disposition of the plurality of types of component group in each of the component supply sections such that a state is assumed in which the nozzles which are attached to each of the mounting heads are fixed during continuous production of the plurality of types of printed circuit board based on a plurality of types of component group to be mounted onto the plurality of types of printed circuit board for which the continuous production is performed, and a production step of performing continuous production of the plurality of types of printed circuit board in the disposition of each of the nozzles and the disposition of the plurality of types of component group which are determined in the condition determination step.

The disposition of the nozzles and the disposition of the plurality of types component group are determined based on the plurality of types of component group to be mounted onto the plurality of types of printed circuit board when performing the continuous production of the plurality of types of printed circuit board. The nozzles which are determined are not exchanged during the continuous production of the plurality of types of printed circuit board. In this manner, since the continuous production of a plurality of types of printed circuit board is performed in a state in which the disposition of the nozzles is fixed, the cycle time is shortened. The disposition of the nozzles is not determined based on the printed circuit boards which are conveyed in each of the plurality of conveyance lanes. Therefore, whichever type of printed circuit board the worker conveys to whichever of the plurality of conveyance lanes, a shortening of the cycle time may be obtained as described above. In other words, the degree of freedom of the conveyance of the plurality of types of printed circuit board is high.

The board production method according to the invention continuously produces one or more types of first printed circuit board and one or more types of second printed circuit board, the condition determination step includes a first condition determination step of determining the disposition of the nozzles which are attached to each of the mounting heads and the disposition of a plurality of types of first component group in each of the component supply sections based on the plurality of types of first component group which are mounted onto the first printed circuit board, and a second condition determination step of determining the disposition of a plurality of types of second component group in each of the component supply sections based on the plurality of types of second component group to be mounted onto the second printed circuit board using a state in which the disposition of each of the nozzles which is determined by the first condition determination step is fixed as a constraint condition, and the production step performs the continuous production of the first printed circuit board and the second printed circuit board in the disposition of each of the nozzles which is determined in the first condition determination step, the disposition of the plurality of types of first component group, and the disposition of the plurality of types of second component group which is determined in the second condition determination step.

The disposition of each of the nozzles is determined with reference to the plurality of types of first component group on the first printed circuit board, and the disposition of the plurality of types of second component group is determined in a state in which the disposition of each of the nozzles which is determined is fixed. Therefore, it becomes possible to produce the second printed circuit board while maintaining an optimal state in the production of the first printed circuit board.

The board production method according to a further aspect, which does not form part of the invention, is obtained by configuring the invention as follows. The board production method is executed based on a production plan in which a fourth board group which includes a plurality of types of fourth printed circuit board is continuously produced, and subsequently, a fifth board group which includes a plurality of types of fifth printed circuit board is continuously produced, the component disposition region in each of the component supply sections is partitioned into a fourth region in which a plurality of types of fourth component group to be mounted onto the fourth board group are disposed, and a fifth region in which a plurality of types of fifth component group to be mounted onto the fifth board group are disposed, fourth nozzles are attached to each of the mounting heads during mounting of the plurality of types of fourth component group, and fifth nozzles are attached to each of the mounting heads during mounting of the plurality of types of fifth component group, and the condition determination step includes a fourth condition determination step of determining the disposition of the fourth nozzles which are attached to each of the mounting heads and the disposition of a plurality of types of fourth component group in each of the component supply sections such that a state is assumed in which the fourth nozzles which are attached to each of the mounting heads during the continuous production of the fourth board group are fixed based on the plurality of types of fourth component group, and a fifth condition determination step of determining the disposition of the fifth nozzles in each of the mounting heads and the disposition of the plurality of types of fifth component group in each of the component supply sections such that a state is assumed in which the fifth nozzles which are attached to each of the mounting heads during the continuous production of the fifth board group are fixed based on the plurality of types of fifth component group.

During the continuous production of the fourth board group, each of the fourth regions in which the fourth component groups are disposed and the fourth nozzles which are attached to each of the mounting heads are used. Meanwhile, during the continuous production of the fifth board group, each of the fifth regions in which the fifth component groups are disposed and the fifth nozzles which are attached to each of the mounting heads are used. Therefore, during the continuous production of the fourth board group, the exchanging of each of the fourth nozzles is not performed, and the cycle time may be shortened. During the continuous production of the fifth board group, the exchanging of each of the fifth nozzles is not performed, and the cycle time may be shortened. Therefore, by grouping the plurality of types of printed circuit boards as groups (the fourth board group or the fifth board group) according to the order of production plan, it is possible to reduce the number of times the nozzle exchange is performed.

By partitioning the component disposition region of the component supply section into the fourth region and the fifth region, when the mounting head uses the fourth component groups of the fourth region, the worker may freely perform a disposition process of the fifth component groups in the fifth region. While the worker is carrying out the disposition process of the fifth component groups in the fifth region, since the mounting heads are performing the mounting of the fourth component groups of the fourth region, even if the worker performs the disposition process of the fifth component groups in the fifth region, the cycle time is not increased.

### Brief Description of Drawings

[Fig. 1] Fig. 1 is a plan view illustrating the configuration of an electronic component mounting system which applies a board production method of a first embodiment of the present invention.
[Fig. 2] Fig. 2 is a diagram illustrating a production plan in the board production method of the first embodiment. Time progresses going from the top side to the bottom side in Fig. 2.
[Fig. 3] Fig. 3 is a flowchart of a condition determination method of the board production method of the first embodiment.
[Fig. 4] Fig. 4 illustrates a timing chart relating to the type of printed circuit board to be conveyed in a first conveyance lane and a second conveyance lane, a condition determination process, exchanging of nozzles, and the disposition process of component groups in a case in which the condition determination method illustrated in Fig. 3 is applied. Time progresses from the top side to the bottom side in Fig. 4.
[Fig. 5] Fig. 5 is a plan view illustrating the configuration of an electronic component mounting system which applies a board production method of a second embodiment, which does not form part of the present invention.
[Fig. 6] Fig. 6 is a diagram which illustrates a production plan (left column in the drawing) in the board production method of the second embodiment, and further illustrates a board group which summarizes the plurality of types of printed circuit board, and a component group and a nozzle group corresponding to the board group. Time progresses from the top side to the bottom side in Fig. 6.
[Fig. 7] Fig. 7 illustrates a timing chart in the second embodiment relating to the types of the printed circuit board to be conveyed in the first conveyance lane and the second conveyance lane, the exchanging of nozzles, and the disposition process of the component groups in a fourth region D4 and a fifth region D5. Time progresses from the top side to the bottom side in Fig. 7.

### Description of Embodiments

### <First Embodiment>

### (Configuration of Electronic Component Mounting System)

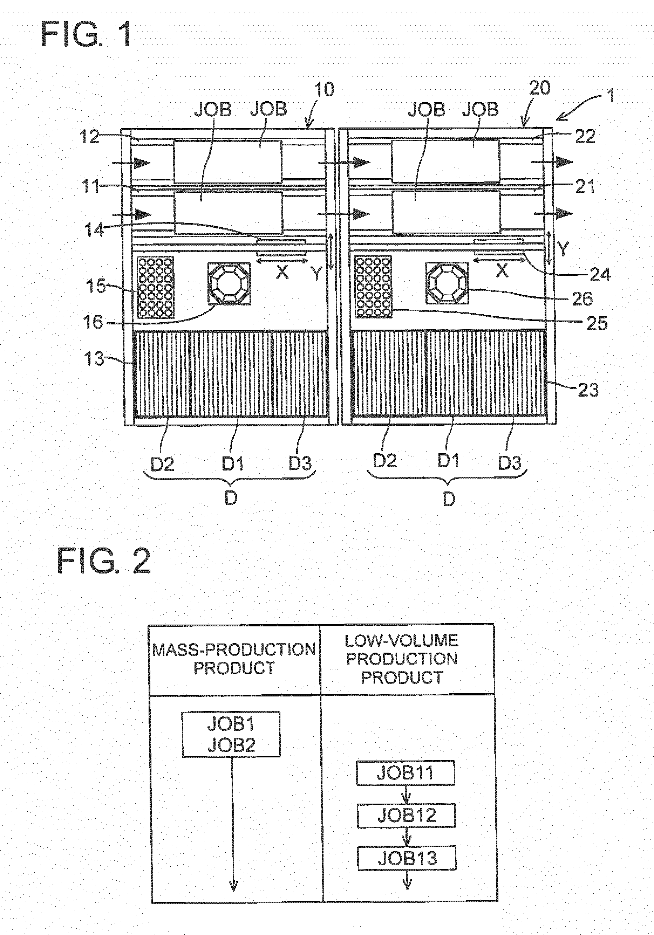

Description will be given of the configuration of an electronic component mounting system 1 with reference to Fig. 1. The electronic component mounting system 1 is provided with a plurality of component mounting machines 10 and 20 which are disposed in series, and performs the continuous production of a plurality of types of printed circuit board. Each of the plurality of component mounting machines 10 and 20 is of a type with dual conveyance lanes and a single mounting head.

The plurality of component mounting machines 10 and 20 are provided with first conveyance lanes 11 and 21 and second conveyance lane 12 and 22 which convey each of a plurality of types of board JOB, single component supply sections 13 and 23, single mounting heads 14 and 24, nozzle stations 15 and 25, and parts cameras 16 and 26.

The first conveyance lanes 11 and 21 and the second conveyance lanes 12 and 22 are disposed in adjacent positions parallel to each other. The first conveyance lanes 11 and 21 and the second conveyance lanes 12 and 22 are capable of positioning the board JOBs which are conveyed at predetermined positions.

The component supply sections 13 and 23 are provided with a component disposition regions D in which each of a plurality of types of component group are disposed. Although described later, the regions D may be used as a plurality of regions D1, D2, and D3 in relation to a plurality of board groups. For example, the component supply sections 13 and 23 are provided with a plurality of tape feeders or a plurality of tray feeders in which a plurality of types of component group are stored. The component supply sections 13 and 23 are disposed on only one side relative to the first conveyance lanes 11 and 21 and the second conveyance lanes 12 and 22. Specifically, the component supply sections 13 and 23 are disposed only on the side close to the first conveyance lanes 11 and 21.

At least one or more nozzles are attached to the mounting heads 14 and 24. For example, twelve nozzles are attached to the mounting head 14, and eight nozzles are attached to the mounting head 24. There is a case in which only one nozzle is attached to the mounting heads 14 and 24. The nozzle holds each of the plurality of types of component group which are supplied from the component supply sections 13 and 23. The mounting heads 14 and 24 are capable of moving in a conveyance direction (an X-axis direction) of Fig. 1, and in a direction (a Y-axis direction) which is perpendicular to the conveyance direction on the printed circuit board plane. The mounting heads 14 and 24 mount each of the plurality of types of component group which are supplied from the component supply sections 13 and 23 onto the plurality of types of printed circuit board which are conveyed in the first conveyance lanes 11 and 21 and the second conveyance lanes 12 and 22.

The nozzle stations 15 and 25 are disposed in a region in which the mounting heads 14 and 24 are capable of moving, and stores a plurality of types of nozzle. The nozzles which are stored in the nozzle stations 15 and 25 are exchangeable with the nozzles which are attached to the mounting heads 14 and 24. Here, the nozzles are different according to the size, the shape, or the like of the components. There are nozzles which are capable of holding a plurality of types of component.

The parts cameras 16 and 26 are disposed between the first conveyance lanes 11 and 21 and the component disposition region D in the Y-direction, in the middle of the conveyance direction (the X-direction) in the component mounting machines 10 and 20. The parts cameras 16 and 26 recognize the components which are held by the mounting heads 14 and 24 by passing above the part cameras 16 and 26 when the mounting heads 14 and 24 convey the components.

### (Production Plan)

Next, the production plan of the printed circuit board which uses the electronic component mounting system 1 illustrated in Fig. 1 will be described with reference to Fig. 2. As illustrated in Fig. 2, the production plan is a plan to continuously produce a plurality of types of board JOBs 1 and 2 (first printed circuit boards) as mass-production products, and to continuously produce board JOBs 11 to 13 (second printed circuit boards) as low-volume production products during continuous production of a plurality of types of board JOBs 1 and 2 as mass-production products.

In other words, the plurality of types of board JOBs 1 and 2 which serve as mass-production products are continuously produced from early production of Fig. 2 to final production. Meanwhile, the production of board JOB 11 which serves as a low-volume production product is started at the same time as the start of continuous production of the board JOBs 1 and 2, or is started in the middle of the continuous production. When the production of board JOB 11 which serves as a low-volume production product is ended, the production of board JOB 12 which serves as the next low-volume production product is started, and when the production of board JOB 12 is ended, the production of board JOB 13 which serves as the next low-volume production product is started.

### (Disposition of Component Groups in Component Supply Section)

Next, description will be given of the disposition of each component group in the component supply sections 13 and 23 with reference to Fig. 1. As illustrated in Fig. 1, a plurality of types of first component group in which a plurality of types of board JOBs 1 and 2 which are mass-production products are mounted are disposed in the first region D1 which is positioned at the center of the component disposition regions D in the component supply sections 13 and 23. Meanwhile, a plurality of types of second component group to be mounted in a plurality of types of board JOBs 11 to 13 which are low-volume production products are disposed in the second regions D2 and D3 other than the first region D1. A plurality of types of second component group for each type of board JOBs 11 to 13 are disposed, while being exchanged, in the second regions D2 and D3. The proportion of the first region D1 is different depending on the number of the plurality of types of first component group. As illustrated in Fig. 1, the proportion of the first region D1 is also different according to the component mounting machines 10 and 20.

Here, the mounting heads 14 and 24 suck the components in the component supply sections 13 and 23, and subsequently pass above the parts cameras 16 and 26 of the center of the machine to move above the board JOB. The first region D1 is positioned in the center of the component disposition region D of the component supply sections 13 and 23, and the second regions D2 and D3 are positioned at the end side of the component disposition region D. Therefore, the distance from the first region D1 to the part cameras 16 and 26 is shorter than the distance from the second regions D2 and D3 to the parts cameras 16 and 26. Therefore, the movement distance of the mounting heads 14 and 24 in a case in which the mounting heads 14 and 24 mount a plurality of types of first component group from the first region D1 onto the board JOB is shorter than the movement distance of the mounting heads 14 and 24 in a case in which the mounting heads 14 and 24 mount a plurality of types of second component group from the second regions D2 and D3 onto the board JOB.

### (Condition Determination Method)

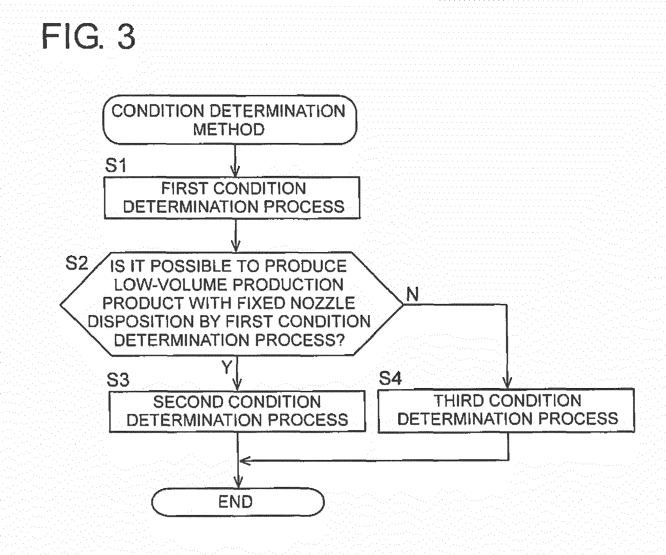

Next, description will be given a determination method of the disposition of the nozzles in each of the mounting heads 14 and 24, and a determination method of the disposition of a plurality of types of component group in each of the component supply sections 13 and 23, with reference to Fig. 3. The condition determination method is executed by a computer which serves as a condition determination device. The condition determination device determines whether or not the board JOBs 11 to 13 of low-volume production products are present based on the production plan. If the board JOBs 11 to 13 of low-volume production products are not present, the condition determination process which is described below is not performed.

Meanwhile, in a case in which the board JOBs 11 to 13 of low-volume production products which are the production target are present, the following processes are performed. The condition determination device first performs the first condition determination process (S1 in Fig. 3: a first condition determination step). The first condition determination process determines the disposition of the nozzles which are attached to each of the mounting heads 14 and 24, and the disposition of the plurality of types of first component group in each of the component supply sections 13 and 23 based on a plurality of types of first component group which are mounted onto a plurality of types of board JOBs 1 and 2 which are mass-production products. Here, the conditions which are determined by the first condition determination process are optimal conditions for mounting the plurality of types of first component group onto the plurality of types of board JOBs 1 and 2 in the plurality of component mounting machines 10 and 20. In other words, in the disposition of the nozzles and the disposition of the first component groups as described above, the cycle time in a case in which only the plurality of types of board JOB 1 and 2 which are mass-production products are produced becomes shortest.

Subsequently, the condition determination device sequentially determines whether or not it is possible to produce the board JOBs 11 to 13 of the low-volume production product in a state in which the disposition of each of the nozzles is fixed using the plurality of types of first component group in the board JOBs 1 and 2 of the mass-production product as a reference (S2 of Fig. 3). In other words, the condition determination device determines whether or not it is possible to produce the board JOBs 11 to 13 of the low-volume production product using a state in which the disposition of the nozzles which is determined by the first condition determination process is fixed as a constraint condition.

In a case in which it is possible to produce the board JOBs 11 to 13 of the low-volume production product in a state with the disposition of the nozzles is fixed using the mass-production product as a reference (S2 of Fig. 3: Y), the condition determination device performs the second condition determination process (S3 of Fig. 3: a second condition determination step). The second condition determination process is performed for each type of board JOBs 11 to 13 of the low-volume production product. The second condition determination process determines the disposition of the plurality of types of second component group in each of the component supply sections 13 and 23 based on the plurality of types of second component group which are mounted onto board JOBs 11 to 13 of the low-volume production product using a state in which the disposition of the nozzles which is determined by the first condition determination process is fixed as a constraint condition. In other words, in the mounting of a plurality of types of second component group, each of the nozzles which is determined as being used for mounting the plurality of types of first component group is used as it is.

The determination of the disposition of the plurality of types of second component group is determined using the second regions D2 and D3. However, among the plurality of types of the second component group, in a case in which a component of the same type as the plurality of types of first component group is present, the first component group which is disposed in the first region D1 is used in the mounting of the second component group onto the board JOBs 11 to 13 of the low-volume production product. In other words, the determination of the disposition of the second component group in the second regions D2 and D3 by the second condition determination process is performed on the component group which is not included in the plurality of types of first component group among the plurality of types of second component group.

Meanwhile, in a case in which it is not possible to produce the board JOBs 11 to 13 of the low-volume production product in a state in which the disposition of each of the nozzles is fixed using the plurality of types of first component group in the board JOBs 1 and 2 of the mass-production product as a reference (S2 of Fig. 3: N), the condition determination device performs the third condition determination process (S4 of Fig. 3: a third condition determination step). The third condition determination process is performed for each type of board JOBs 11 to 13 of the low-volume production product. The third condition determination process performs the redetermination of the disposition of the nozzles and the determination of the disposition of the plurality of types of second component group using a state in which the disposition of the plurality of types of first component group which is determined by the first condition determination process is fixed as a constraint condition.

The redetermination of the disposition of the nozzles determines the disposition of nozzles which are capable of producing both printed circuit boards of the mass-production product and the printed circuit boards of the target low-volume production product. Here, in a case in which it is not possible to produce the board JOBs 11 to 13 of the low-volume production product in a state in which the disposition of the nozzles is fixed, at least a portion of the plurality of types of second component group may not be mounted with only the nozzles which are determined in the first condition determination process. Therefore, nozzles for mounting at least a portion of the plurality of types of second component group are necessary.

However, when a nozzle for mounting at least a portion of a plurality of types of second component group is a nozzle which is dedicated to the second component group, since the number of nozzles for mounting the plurality of types of first component group decreases by the number of dedicated nozzles, the production efficiency of board JOBs 1 and 2 of mass-production products is decreased. Therefore, the condition determination device may redetermine the disposition of the nozzles so as to use nozzles which are not included in the nozzles which are determined by the first condition determination process and which may also be commonly used for the mounting of the second component groups and the mounting of the first component groups. That is, due to the commonly usable nozzles being used, lowering of the production efficiency of the board JOBs 1 and 2 of mass-production product is suppressed in comparison with a case in which dedicated nozzles of the second component group are used.

In the same manner as the second condition determination process, the determination of the disposition of the plurality of types of second component group in the third condition determination process is performed on the component groups which are not included in the plurality of types of first component group among the plurality of types of second component group.

### (Timing of Operations in Board Production)

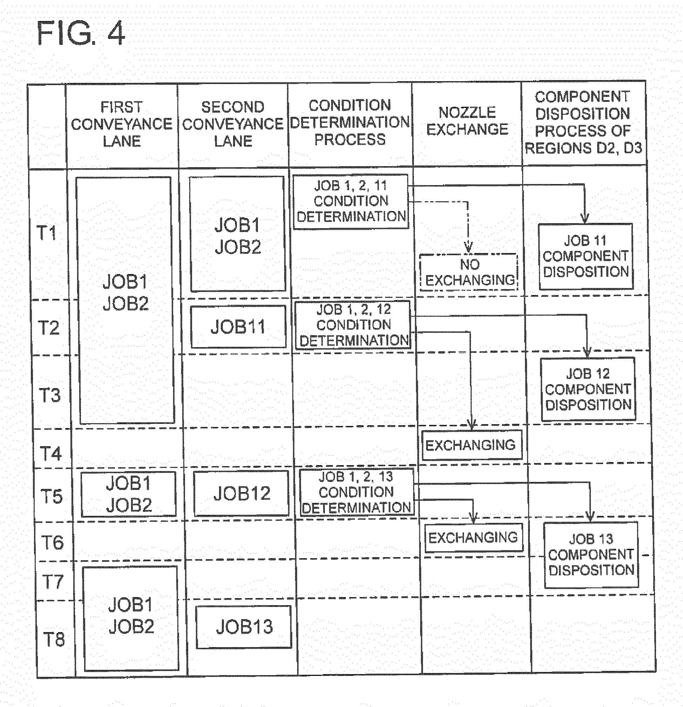

Next, in a case in which the board production is carried out based on the production plan illustrated in Fig. 2, the types of the board JOB to be conveyed in the first conveyance lanes 11 and 21 and the second conveyance lanes 12 and 22, the condition determination process, the exchanging of the nozzles, the disposition process of the component groups will be described with reference to Fig. 4.

Here, as a prerequisite in the present embodiment, the board JOBs 11 and 13 of the low-volume production product may be produced by each of the nozzles which are determined based on the first component groups which are mounted onto the board JOBs 1 and 2 of the mass-production product. Meanwhile, it is assumed that the board JOB 12 of the low-volume production product may not be produced by each of the nozzles which are determined based on the first component groups which are mounted onto the board JOBs 1 and 2 of the mass-production product.

At T1 in Fig. 4, the board JOBs 1 and 2 of mass-production product are the production targets. At this time, the board JOB 1 or the board JOB 2 are conveyed in the first conveyance lanes 11 and 21 and the second conveyance lanes 12 and 22. The component mounting machines 10 and 20 perform the production of the board JOBs 1 and 2 of the mass-production product (a production step) . At this time, the nozzles which are attached to each of the mounting heads 14 and 24 are assumed to be at the dispositions which are determined in the first condition determination process. In other words, the nozzles are disposed to be optimal for the board JOBs 1 and 2, and the nozzles are not exchanged during continuous production of the board JOBs 1 and 2.

Here, at T1, not only in a case in which the board JOB 1 is conveyed to one of the first conveyance lanes 11 and 21 and the second conveyance lanes 12 and 22 and the board JOB 2 is conveyed to the other, but there is a case in which the same type of board JOB 1 or a case in which the same type of board JOB 2 is conveyed to both of the first conveyance lanes 11 and 21 and the second conveyance lanes 12 and 22.

At T1, the condition determination process is performed by the condition determination device. The condition determination process here is a process for the production step of adding the production of the board JOB 11 of the low-volume production product. In other words, the next production step is a step of continuously producing the board JOB 11 of a low-volume production product while continuously producing the board JOBs 1 and 2 of the mass-production product.

Therefore, at T1, the condition determination device executes the condition determination process which is illustrated in Fig. 3 based on the plurality of types of board JOB 1, 2 and 11. The first condition determination process (S1 of Fig. 3) relating to the board JOBs 1 and 2 of the mass-production product is already executed. Here, as described above, the board JOB 11 of the low-volume production product may be produced by each of the nozzles which are determined based on the first component group which is mounted onto the board JOBs 1 and 2 of the mass-production product. Therefore, S2: Y is assumed in Fig. 3, the second condition determination process of S3 is performed, and the disposition of the plurality of types of second component group which are mounted onto the board JOB 11 is determined.

Therefore, the nozzles are not exchanged for the production steps of the board JOBs 1, 2, and 11 before the production of the board JOB 11 of the low-volume production product is started (T1 of Fig. 4). At T1, the worker disposes the second component group which is mounted onto the board JOB 11 based on the disposition which is determined by the condition determination device. At this time, the second component group which is mounted onto the board JOB 11 is disposed in the second regions D2 and D3 (illustrated in Fig. 1) of the component supply sections 13 and 23. Here, since the second regions D2 and D3 are region which are not used in the production of the board JOBs 1 and 2 of the mass-production product, the worker is capable of performing the disposition process of a plurality of types of the second component group during the continuous production of the board JOBs 1 and 2 of the mass-production product.

Subsequently, when the disposition process of the plurality of types of second component group is ended at T1 of Fig. 4, at T2 of Fig. 4, the board JOBs 1 and 2 of the mass-production product are conveyed to the first conveyance lanes 11 and 21, and the board JOB 11 of the low-volume production product is conveyed to the second conveyance lanes 12 and 22. The distance between the first conveyance lanes 11 and 21 and the component supply sections 13 and 23 is shorter than the distance between the second conveyance lanes 12 and 22 and the component supply sections 13 and 23. Therefore, due to the board JOBs 1 and 2 of the mass-production product being conveyed in the first conveyance lanes 11 and 21, the movement distance of the mounting heads 14 and 24 is shortened during the production of the board JOBs 1 and 2 of the mass-production product. Therefore, the cycle time which is necessary for the production of the board JOBs 1 and 2 of the mass-production product is shortened.

Since the mounting heads 14 and 24 suck the components at the component supply sections 13 and 23 and subsequently pass over the parts cameras 16 and 26 at the center of the device and move over the board JOBs, the movement distance of the mounting heads 14 and 24 from the first region D1 to the board JOB is shorter than the movement distance of the mounting heads 14 and 24 from the second regions D2 and D3 to the board JOB. A plurality of types of first component group to be mounted onto board JOBs 1 and 2 of the mass-production product are disposed in the first region D1. Therefore, the movement distance of the mounting heads 14 and 24 is shortened during the production of the board JOBs 1 and 2 of the mass-production product. Therefore, even by these means, the cycle time which is necessary for the production of the board JOBs 1 and 2 of the mass-production product is shortened.

Since the nozzle exchange is not performed during a period from T1 to T2, the disposition of the nozzles at T2 is the same as the disposition of the nozzles at T1. In other words, even at T2, the nozzles which are attached to the mounting heads 14 and 24 are disposed to be optimal in relation to the board JOBs 1 and 2 of the mass-production product, and the exchanging of the nozzles is not performed during the continuous production of the board JOBs 1, 2, and 11.

Therefore, at T2, the board JOBs 1 and 2 of the mass-production product are produced with the nozzle disposition, which is determined using the board JOBs 1 and 2 of the mass-production product as a reference, as it is. As a result, the production of the board JOBs 1 and 2 of the mass-production product is maintained in an optimal state (a state in which the cycle time is shortened) . While the optimal state is maintained for the board JOBs 1 and 2 of the mass-production product, the production of the board JOB 11 of the low-volume production product is performed. Here, for the board JOB 11 of the low-volume production product, even a system configuration which optimizes the cycle time is not adopted, ordinarily there is no problem for the low-volume production product.

At T2, the condition determination process in relation to the next production step is performed in the condition determination device. The next production step is a step of performing the continuous production of the board JOB 12 of the low-volume production product instead of the production of the board JOB 11 while continuously producing the board JOBs 1 and 2 of the mass-production product.

Therefore, at T2, the condition determination device executes the condition determination process illustrated in Fig. 3 based on the plurality of types of board JOB 1, 2, and 12. Here, as described above, the board JOB 12 of the low-volume production product is not possible to produce using the nozzles which are determined based on the first component group which is mounted onto the board JOBs 1 and 2 of the mass-production product. Therefore, S2: N is assumed in Fig. 3, the third condition determination process of S4 is performed, and redetermination of the disposition of the nozzles and the determination of the disposition of the plurality of types of second component group which are mounted onto the board JOB 12 are performed.

Therefore, after the ending of the production of the board JOB 11 at T2 in Fig. 4, the worker disposes the second component group which is mounted onto the board JOB 12 based on the determined disposition of the second component group at T3 of Fig. 4. At this time, the second component group which is mounted onto the board JOB 12 is disposed in the second regions D2 and D3 (illustrated in Fig. 1) of the component supply sections 13 and 23. In other words, in the second regions D2 and D3, the worker performs the disposition changing process from the plurality of types of second component group which are mounted onto the board JOB 11 which is the previous production target, to the plurality of types of second component group to be mounted onto the board JOB 12 which is the next production target. Here, during the disposition changing process of the second component group, the production of the board JOBs 1 and 2 of the mass-production product is continuously performed in the first conveyance lanes 11 and 21.

Subsequently, when the disposition changing process of the second component group at T3 in Fig. 4 is ended, the exchanging of the nozzles is performed at T4 in Fig. 4. The nozzles are disposed based on the disposition which is determined in the third condition determination process at T2. At this time, the production of the board JOBs 1 and 2 of the mass-production product in the first conveyance lanes 11 and 21 is temporarily stopped. Here, the nozzles after the exchange by T4 may not be said to be optimal for the production of only the board JOBs 1 and 2. Therefore, in order to prolong the production of the board JOBs 1 and 2 by the optimal nozzles before the exchanging, the exchanging to nozzles which are not optimal is performed after the ending of the disposition changing process of the second component group.

Subsequently, when the exchanging of the nozzles at T4 in Fig. 4 is ended, at T5 of Fig. 4, the production of the board JOBs 1 and 2 of the mass-production product and the production of the board JOB 12 of the low-volume production product are started. In other words, at T5, the board JOBs 1 and 2 of the mass-production product are continuously produced in the first conveyance lanes 11 and 21, and the board JOB 12 of the low-volume production product is continuously produced at the second conveyance lanes 12 and 22.

Here, the third condition determination process which is performed at T2 in Fig. 4 is performed using a state in which the disposition of the nozzles which are determined by the first condition determination process is fixed as a constraint condition. Therefore, the disposition of the first component group which is mounted onto the board JOBs 1 and 2 of the mass-production product is not changed at T3 in Fig. 4. Therefore, as soon as the nozzle exchange at T4 in Fig. 4 is ended, the production of the board JOBs 1 and 2 is started.

At T5, the condition determination process in relation to the next production step is performed in the condition determination device. The next production step is a step of performing the continuous production of the board JOB 13 of the low-volume production product instead of the production of the board JOB 12 while continuously producing the board JOBs 1 and 2 of the mass-production product.

Therefore, at T5, the condition determination device executes the condition determination process which is illustrated in Fig. 3 based on the plurality of types of board JOB 1, 2 and 13. Here, as described above, the board JOB 13 of the low-volume production product may be produced by each of the nozzles which are determined based on the first component group which is mounted onto the board JOBs 1 and 2 of the mass-production product. Therefore, S2: Y is assumed in Fig. 3, the second condition determination process of S3 is performed, and the disposition of the plurality of types of second component group which are mounted onto the board JOB 13 is determined. In this case, the disposition of the nozzles means returning to the original disposition after the ending of the production of the board JOB 12, that is, to the disposition of the nozzles at T1 to T3.

Therefore, after the end of the production of the board JOB 12 at T5 of Fig. 4, the production of the board JOBs 1 and 2 of the mass-production product in the first conveyance lanes 11 and 21 is temporarily stopped. In T6 in Fig. 4, the nozzle exchange is performed, and the disposition of the nozzles in the initial state is restored. In other words, the nozzles are disposed based on the disposition which is determined in the first condition determination process at the beginning of the current production.

The worker disposes the second component group which is mounted onto the board JOB 13 based on the determined disposition of the second component group. In other words, in a case in which the disposition of the nozzles is returned to the optimal state for the production of JOBs 1 and 2, and the nozzle exchange is performed at the same time as the disposition changing process of the second component group. At this time, the second component group which is mounted onto the board JOB 13 is disposed in the second regions D2 and D3 (illustrated in Fig. 1) of the component supply sections 13 and 23. In other words, in the second regions D2 and D3, the worker performs the disposition changing process from the plurality of types of second component group which are mounted onto the board JOB 12 which is the previous production target, to the plurality of types of second component group to be mounted onto the board JOB 13 which is the next production target.

Subsequently, when the exchanging of the nozzles is ended at T6 in Fig. 4, at T7 of Fig. 4, the production of the board JOBs 1 and 2 of the mass-production product is started and the disposition changing process of the second component group which is mounted onto the board JOB 13 is continued. Here, the nozzles after the exchanging by T6 is optimal for the production of only the board JOBs 1 and 2. Therefore, in order to prolong the production of the board JOBs 1 and 2 by the optimal nozzles after the exchanging, the exchanging of the nozzles for restoring the optimal nozzles is performed at the same time as the disposition changing process of the second component group.

Subsequently, when the disposition changing process to the second component group which is mounted onto the board JOB 13 in the second regions D2 and D3 of the low-volume production product is ended, the production of the board JOB 13 of the low-volume production product is started at T8 of Fig. 4. In other words, at T8, the board JOBs 1 and 2 of the mass-production product are continuously produced in the first conveyance lanes 11 and 21, and the board JOB 13 of the low-volume production product is continuously produced at the second conveyance lanes 12 and 22.

The production of the board JOBs 1 and 2 of the mass-production product at T7 and T8 of Fig. 4 is in an optimal state (a state in which the cycle time is shortened) in the same manner as in T1 to T3 of Fig. 4. Here, during the period from T1 to T8 in Fig. 4, the disposition of the first component group which is mounted onto the board JOBs 1 and 2 of the mass-production product is not changed, while being disposed in the first region D1. The reason for this is that the condition determination device uses the state in which the disposition of the first component group which is mounted onto the board JOBs 1 and 2 of the mass-production product is fixed as a constraint condition in the second condition determination process and the third condition determination process.

Therefore, with respect to the board JOBs 1 and 2 of the mass-production product, only the nozzles are changed to be returned to the initial state at T6 in Fig. 4, so that the production of the board JOBs 1 and 2 of the mass-production product at T7 and T8 of Fig. 4 is in an optimal state. Therefore, the time which is necessary for changing the production targets of the board JOBs 11 to 13 of the low-volume production product may be short. In this manner, at T6 of Fig. 4, the worker may return to the optimal state for the production of the board JOBs 1 and 2 of mass-production product in a short time.

As described above, when the continuous production of a plurality of types of printed circuit board (for example, the JOBs 1, 2, and 11) is performed, the disposition of the nozzles and the disposition of the plurality of types component group are determined based on the plurality of types of component group to be mounted onto the plurality of types of printed circuit board (for example, the JOBs 1, 2, and 11). The nozzles which are determined are not exchanged during the continuous production of the plurality of types of printed circuit board (for example, the JOBs 1, 2, and 11). In this manner, since the continuous production of a plurality of types of printed circuit board (for example, the JOBs 1, 2, and 11) is performed in a state in which the disposition of the nozzles is fixed, the cycle time is shortened. The disposition of the nozzles is not determined based on the printed circuit boards which are conveyed in each of the plurality of conveyance lanes 11, 12, 21, and 22. Therefore, whichever type of board JOB the worker conveys to whichever of the first conveyance lanes 11 and 21 and the second conveyance lanes 12 and 22, a shortening of the cycle time may be obtained as described above. In other words, the degree of freedom of the conveyance of the plurality of types of board JOB is high.

In the first condition determination process (S1 of Fig. 3), the disposition of the nozzles is determined using a plurality of types of first component group in the board JOBs 1 and 2 of the mass-production product as a reference, and in the second condition determination process (S3 of Fig. 3), the disposition of a plurality of types of second component group is determined in a state in which the disposition of the nozzles which is determined in the first condition determination process is fixed. Therefore, at T2, T3, and T8 of Fig. 4, it is possible to produce the board JOBs 11 and 13 of the low-volume production product while maintaining the optimal state for the production of the board JOBs 1 and 2 of the mass-production product.

In the present embodiment, the condition determination process relating to the board JOBs 1. 2 and 11, the condition determination process relating to the board JOBs 1, 2 and 12, and the condition determination process relating to the board JOBs 1, 2, and 13 are performed during the corresponding productions; however, the processes may be carried out in advance before starting the production.

### <Second Embodiment>

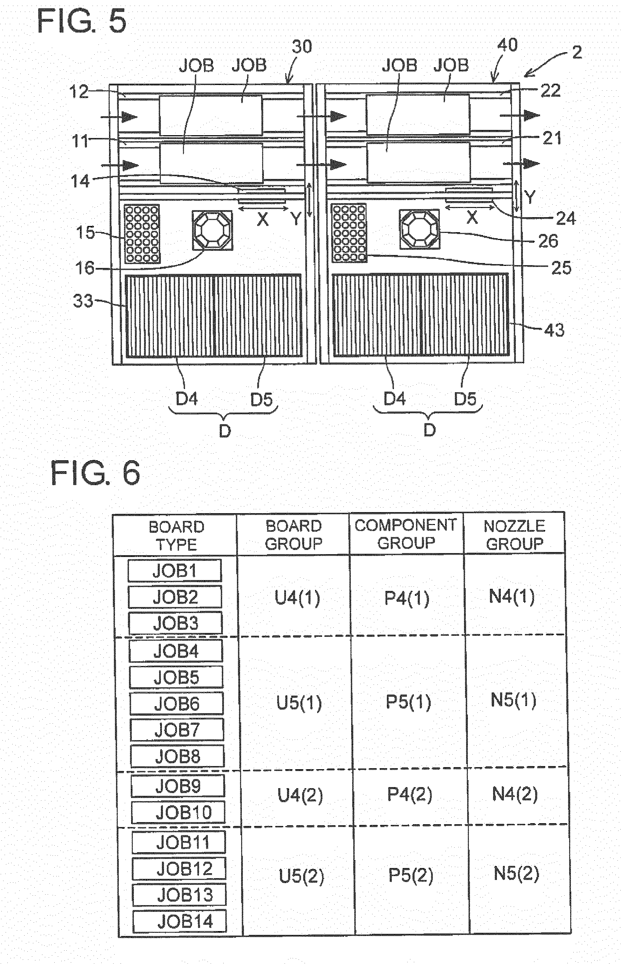

Description will be given of the configuration of an electronic component mounting system 2 of the present embodiment, which does not form part of the invention, with reference to Fig. 5. However, among the configurations in the system 2 of the present embodiment, the configurations which are the same as those in the system 1 of the embodiment described above will be given the same reference numerals. The component disposition region D of each of the component supply sections 33 and 43 is partitioned into a fourth region D4 (the left-side region of Fig. 5) in which the plurality of types of fourth component group are disposed, and a fifth region D5 (the right-side region of Fig. 5) in which the plurality of types of fifth component group are disposed. The fourth region D4 and the fifth region D5 have regions of approximately the same extent, and substantially the same number of tape feeders or tray feeders are disposed in the fourth region D4 and the fifth region D5.

### (Production Plan and Condition Determination Method)

Next, description will be given of the production plan of the printed circuit board which uses the electronic component mounting system 2 illustrated in Fig. 5 with reference to Fig. 6. As illustrated in Fig. 6, the production plan is a plan which sequentially produces and ends the plurality of types of board JOB 1 to 14. However, in the individual board groups which are described later, the printed circuit boards are not limited to being produced in order. For example, the production of the board JOB 2 is not limited to being performed after the production of the board JOB 1 is ended, and producing the board JOB 2 at the same time as the board JOB 1 may be permitted.

Next, description will be given of the condition determination method relating to the disposition of the nozzles in the mounting heads 14 and 24 and the condition determination method relating to the disposition of the plurality of types of component group in each of the component supply sections 33 and 43 with reference to Fig. 6. As illustrated in Fig. 6, the board JOBs 1 to 3 are set to a fourth board group U4(1), the board JOBs 4 to 8 are set to a fifth board group U5(1), the board JOBs 9 to 10 are set to a fourth board group U4(2), and the board JOBs 11 to 14 are set to a fifth board group U5 (2) . The fourth and fifth board groups U4 and U5 mean a group of a plurality of types of board JOB in which the production order is continuous.

Here, each of the fourth board groups U4(1) and U4(2) and the fifth board groups U5(1) and U5(2) is a group in which the production of the board JOB included in each of the board groups is performed in a state in which the disposition of each of the nozzles N4(1), N4(2), N5(1), and N5(2) is fixed, that is, without performing the exchanging of the nozzles. Here, the group is a group of a plurality of types of board JOB for which the production may be ended by a production end target time in addition to being the number of components which may be disposed in the component supply sections 13 and 23 in a case in which the production is performed in a state in which the disposition of the nozzles is fixed with respect to the plurality of types of board JOB in which the production order is continuous.

For example, a plurality of types of board JOB 1 to 3 are included in the fourth board group U4(1), a plurality of types of fourth component group P4(1) are mounted onto the plurality of types of board JOB 1 to 3, and a plurality of types of fourth nozzle N4(1) are used in the mounting of the plurality of types of the fourth component group P4(1). In other words, the disposition of the fourth nozzle N4(1) in each of the mounting heads 14 and 24 and the disposition of the plurality of types of fourth component group P4(1) in each of the component supply sections 13 and 23 are determined such that the fourth nozzle N4 (1) which is attached to each mounting heads 14 and 24 during the continuous production of the fourth board group U4(1) is in a fixed state (the fourth condition determination step). In other words, the mounting of the plurality of types of component group P4 (1) is performed while the plurality of types of fourth nozzle N4(1) remain in a state of being attached to the mounting heads 14 and 24.

The plurality of types of fourth component group P4(1) are component groups which are disposed in the fourth region D4 (illustrated in Fig. 5) in the component disposition region of the component supply sections 33 and 43. The number of types of the plurality of types of fourth component group P4(1) is less than or equal to the maximum disposition number of the fourth region D4. The fourth region D4 is approximately half of the component disposition region of all of the component supply sections 13 and 23.

Here, the determination of the fourth board group U4 (1) is performed as follows. First, it is determined as to whether or not it is possible to place a plurality of types of component group which are mounted onto the board JOBs 1 and 2 in the fourth region D4. In this case, the disposition of the nozzles is determined such that the nozzles which are attached to the mounting heads 14 and 24 are common in JOBS 1 and 2. As a result, in a case in which it is determined that the component may not all be disposed or that the nozzles may not be disposed in common, the fourth board group U4(1) becomes only the board JOB 1.

Meanwhile, in a case in which it is determined that the disposition of the components and the common disposition of the nozzles are possible, it is determined whether the component groups to which the plurality of types of component group which are mounted onto the next board JOB 3 are added may be placed in the fourth region D4 and whether the nozzles may be disposed in common. In a case in which if it is determined that component may not all be disposed or that the nozzles may not be disposed in common, the fourth board group U4(1) becomes the board JOBs 1 and 2.

In a case in which it is determined that the disposition of the components and the common disposition of the nozzles are possible, it is determined whether the component groups to which the plurality of types of component group which are mounted onto the next board JOB 4 are added may be placed in the fourth region D4 and whether the nozzles may be disposed in common. Hereinafter, the printed circuit board of the fourth board group U4(1) is repeatedly determined. In the present example, the board JOBs 1 to 3 are determined as the printed circuit boards of the fourth board group U4(1).

Next, the fifth board group U5(1) is also determined in the same manner as the fourth board group U4(1). First, it is determined as to whether or not it is possible to place a plurality of types of component group which are mounted onto the board JOBs 4 and 5 in the fifth region D5. In this case, the disposition of the nozzles is determined such that the nozzles which are attached to the mounting heads 14 and 24 are common in JOBS 4 and 5. Hereinafter, processing is performed in the same manner as the determination process of the fourth board group U4(1), and the printed circuit board of the fifth board group U5(1) is determined. In the present example, the board JOBs 4 to 8 are set as the printed circuit boards of the fifth board group U5 (1). The plurality of types of board JOB 1 to 14 are grouped so as to alternate between the fourth board group U4 and the fifth board group U5.

### (Timing of Operations in Board Production)

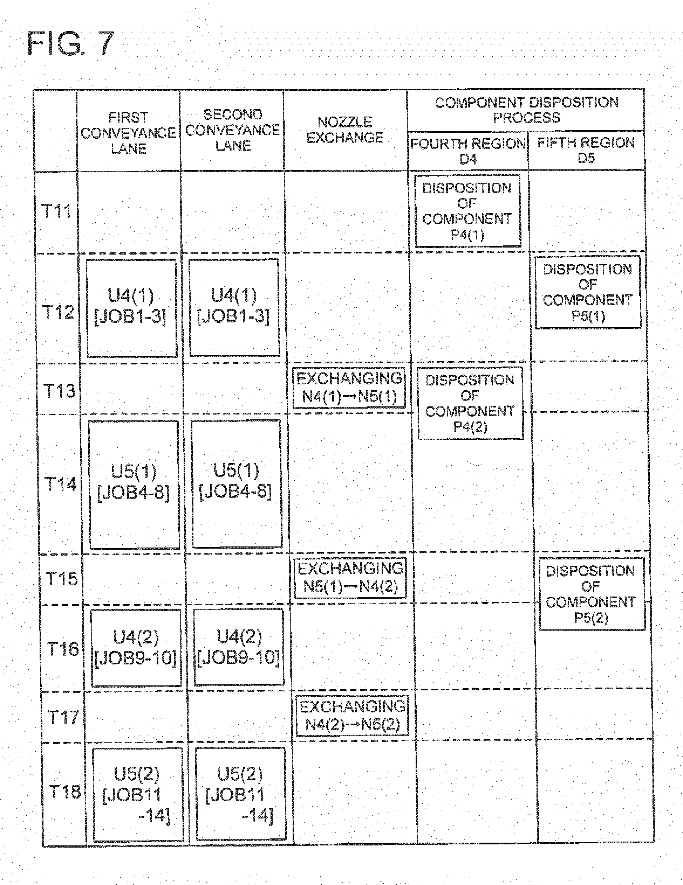

Next, in a case in which the board production is performed based on the production plan illustrated in Fig. 6, the types of the board JOB to be conveyed in the first conveyance lanes 11 and 21 and the second conveyance lanes 12 and 22, the exchanging of the nozzles, and the disposition process of the fourth component group and the fifth component group will be described with reference to Fig. 7.

At T11 of Fig. 7, the worker disposes the fourth component group P4 (1) of the board JOBs 1 to 3 which are included in the fourth board group U4(1) in the fourth region D4. Here, the fourth component group P4(1) is determined in advance based on the production plan (a fourth condition determination step) . Subsequently, at T12 of Fig. 7, the board JOBs 1 to 3 are conveyed to the first conveyance lanes 11 and 21 and the second conveyance lanes 12 and 22. Therefore, the board JOBs 1 to 3 are continuously produced (the production step) . During the continuous production of the board JOBs 1 to 3, the fourth nozzle N4(1) is not changed.

For example, at T12, different board JOBs among the board JOBs 1 to 3 may be conveyed in one and the other of the first conveyance lanes 11 and 21 and the second conveyance lanes 12 and 22, and the same types of board JOB may be conveyed in both of the first conveyance lanes 11 and 21 and the second conveyance lanes 12 and 22.

At T12, the worker disposes the fifth component group P5(1) of the board JOBs 4 to 8 which are included in the fifth board group U5(1) in the fifth region D5. In other words, during the production of the board JOBs 1 to 3 which are included in the fourth board group U4(1), the worker is capable of performing a disposition process of the fifth component group P5(1) of the next fifth board group U5(1). Here, the fifth component group P5(1) is determined in advance based on the production plan (a fifth condition determination step).

Subsequently, after production of the fourth board group U4 (1) is ended, the nozzle exchange from the fourth nozzle N4(1) to the fifth nozzle N5(1) is performed at T13 in Fig. 7. As described above, the fifth nozzle N5(1) is determined in advance based on the production plan (the fifth condition determination step) . During the nozzle exchange, the mounting heads 14 and 24 are stopped.

At T13 of Fig. 7, the worker further disposes the fourth component group P4 (2) which is used for the fourth board group U4 (2) which is the next production target in the fourth region D4. However, the fourth component group P4(1) which is used for the fourth board group U4(1) which is the previous production target is disposed in the fourth region D4. Therefore, the worker performs the disposition changing process from the previous fourth component group P4(1) to the next fourth component group P4 (2) in the fourth region D4. Here, the fourth component group P4 (2) is determined in advance based on the production plan (the fourth condition determination step).

Subsequently, when the exchanging of the nozzles is ended, even if the disposition changing process of the next fourth component group P4(2) is not ended, at T14 of Fig. 7, the board JOBs 4 to 8 which are included in the fifth board group U5(1) are conveyed in the first conveyance lanes 11 and 21 and the second conveyance lanes 12 and 22. Therefore, the board JOBs 4 to 8 are continuously produced (the production step) . During the continuous production of the board JOBs 4 to 8, the fifth nozzle N5(1) is not changed.

Here, as illustrated at T14 of Fig. 7, in the fourth region D4, the disposition changing process of the next fourth board group U4(2) to the fourth component group P4(2) is also performed during the production of the fifth board group U5 (1). In other words, the disposition preparation of the next component is performed during the production of another printed circuit board or during the nozzle exchange. Therefore, a lengthening of the overall cycle time is suppressed.

Subsequently, after production of the fifth board group U5 (1) is ended, the nozzle exchange from the fifth nozzle N5 (1) to the fourth nozzle N4(2) is performed at T15 in Fig. 7. As described above, the fourth nozzle N4(2) is determined in advance based on the production plan (the fourth condition determination step) . During the nozzle exchange, the mounting heads 14 and 24 are stopped.

At T15 of Fig. 7, the worker further disposes the fifth component group P5(2) which is used for the fifth board group U5(2) which is the next production target in the fifth region D5. However, the fifth component group P5(1) which is used for the fifth board group U5 (1) which is the previous production target is disposed in the fifth region D5. Therefore, the worker performs the disposition changing process from the previous fifth component group P5(1) to the next fifth component group P5(2) in the fifth region D5. Here, the fifth component group P5(2) is determined in advance based on the production plan (the fifth condition determination step).

Subsequently, the board JOBs 9 and 10 which are included in the fourth board group U4(2) are produced at T16 in Fig. 7, the nozzle exchange to the fifth nozzle N5(2) is performed at T17, and the board JOBs 11 to 14 which are included in the fifth board group U5(2) are produced at T18.

As described above, during the continuous production of the fourth board groups U4(1) and U4(2), and the fifth board groups U5(1) and U5(2), the fourth nozzles N4(1) and N4(2), and the fifth nozzles N5(1) and N5(2) are not exchanged, and the cycle time may be shortened. Therefore, by grouping the plurality of types of board JOBs 1 to 14 as groups (the fourth board groups U4(1) and U4(2) or the fifth board groups U5(1) and U5(2)) according to the order of production plan, it is possible to reduce the number of times the nozzle exchange is performed.

By partitioning the component disposition region of the component supply sections 13 and 23 into the fourth region D4 and the fifth region D5, when the mounting heads 14 and 24 use the fourth component groups P4(1) and P4(2) of the fourth region D4, the worker may freely perform a disposition process of the fifth component groups P5(1) and P5(2) in the fifth region D5 . While the worker is carrying out the disposition process of the fifth component groups P5(1) and P5(2) in the fifth region D5, since the mounting heads 14 and 24 are performing the mounting of the fourth component groups P4(1) and P4 (2) of the fourth region D4, even if the worker performs the disposition process of the fifth component groups P5(1) and P5(2) in the fifth region D5, the cycle time is not increased.

### Reference Signs List

1, 2: electronic component mounting system, 10, 20: component mounting machine, 11, 21: first conveyance lane, 12, 22: second conveyance lane, 13, 23, 33, 43: component supply section, 14, 24: mounting head, 15, 25: nozzle station, D1: first region, D2, D3: second region, D4: fourth region, D5: fifth region, JOB: printed circuit board

## Claims

1. A board production method for performing continuous production of a plurality of types of printed circuit board (JOB) using a plurality of component mounting machines (10,20) which are disposed in series,
wherein each of the plurality of component mounting machines (10, 20) includes
a plurality of conveyance lanes (11, 12, 21, 22) which convey the plurality of types of printed circuit board (JOB),
a component supply section (13, 23, 33, 43) which includes a component disposition region in which a plurality of types of component group are disposed, and
a single mounting head (14, 24) to which at least one or more nozzles are attached and which mounts the plurality of types of component group which are supplied from the component supply section (13, 23, 33, 43) onto the printed circuit board (JOB) which is conveyed in the conveyance lanes (11, 12, 21, 22), and
wherein the board production method comprises:
a condition determination step of determining a disposition of the nozzles in each of the mounting heads (14, 24) and a disposition of the plurality of types of component groups in each of the component supply sections (13, 23, 33, 43) such that a state is assumed in which the nozzles which are attached to each of the mounting heads (14, 24) are fixed, that is, the nozzles are not exchanged, during continuous production of the plurality of types of printed circuit board (JOB) based on a plurality of types of component group to be mounted onto the plurality of types of printed circuit board (JOB) for which the continuous production is performed; and
a production step of performing continuous production of the plurality of types of printed circuit board (JOB) in the disposition of each of the nozzles and the disposition of the plurality of types of component group which are determined in the condition determination step,
wherein the board production method continuously produces one or more types of first printed circuit board (JOB) and one or more types of second printed circuit board (JOB),
wherein the condition determination step includes
a first condition determination step of determining the disposition of the nozzles which are attached to each of the mounting heads (14, 24) and the disposition of a plurality of types of first component group in each of the component supply sections (13, 23, 33, 43) based on the plurality of types of first component group which are mounted onto the first printed circuit board (JOB), and
a second condition determination step of determining the disposition of a plurality of types of second component group in each of the component supply sections (13, 23, 33, 43) based on the plurality of types of second component group to be mounted onto the second printed circuit board (JOB) using a state in which the disposition of each of the nozzles which is determined by the first condition determination step is fixed as a constraint condition, and
wherein the production step performs the continuous production of the first printed circuit board (JOB) and the second printed circuit board (JOB) in the disposition of each of the nozzles which is determined in the first condition determination step, the disposition of the plurality of types of first component group, and the disposition of the plurality of types of second component group which is determined in the second condition determination step,
wherein the first printed circuit board (JOB) is a printed circuit board (JOB) of a mass-production product, and
wherein the second printed circuit board (JOB) is a printed circuit board (JOB) of a low-volume production product,
wherein the component supply section (13, 23, 33, 43) is disposed only on a side which is close to a first conveyance lane (11, 21) among the plurality of conveyance lanes (11, 12, 21 ,22),
wherein the first conveyance lane (11, 21) conveys only the printed circuit board (JOB) of the mass-production product, and
wherein the printed circuit board (JOB) of the low-volume production product is conveyed in only a second conveyance lane (12, 22) which is positioned on a side which is far from the component supply section (13, 23, 33, 43) among the plurality of conveyance lanes (11, 12, 21, 22).

2. The board production method according to Claim 1,
wherein the second condition determination step determines the disposition of the plurality of types of second component group using a second region (D2, D3) other than a first region (D1) in which the plurality of types of first component group are disposed in the component disposition region.

3. The board production method according to Claim 2,
wherein the second condition determination step determines the disposition of the plurality of types of second component group using the second region (D2, D3) for each type of the second printed circuit board (JOB), and
wherein in the second region (D2, D3), a disposition changing process from the plurality of types of second component group which are mounted onto the second printed circuit board (JOB), which is a previous production target, to the plurality of types of second component group which are mounted onto the second printed circuit board (JOB), which is a next production target, is performed during production of the first printed circuit board (JOB).

4. The board production method according to any one of the preceding claims,
wherein, in a case in which production of the second printed circuit board (JOB) is not possible when a state in which the disposition of each of the nozzles which is determined by the first condition determination step is fixed is used as a constraint condition, the condition determination step includes a third condition determination step of performing redetermination of the disposition of the nozzles which are attached to each of the mounting heads (14, 24) and determination of the disposition of the plurality of types of second component group while using a state in which the disposition of the plurality of types of first component group which are determined by the first condition determination step is fixed as a constraint condition and using nozzle which is not included in the nozzles which are determined in the first condition determining step and which may be commonly used for mounting of the second component group and mounting of the first component group.

## Patentansprüche

1. Leiterplattenherstellungsverfahren zum Durchführen einer kontinuierlichen Herstellung einer Vielzahl von Typen von Leiterplatten (JOB) unter Verwendung einer Vielzahl von Komponentenmontagemaschinen (10, 20), die in Reihe angeordnet sind,
wobei jede aus der Vielzahl von Komponentenmontagemaschinen (10, 20) beinhaltet:
eine Vielzahl von Förderbahnen (11, 12, 21, 22), die die Vielzahl von Typen von Leiterplatten (JOB) befördern,
einen Komponentenzuführabschnitt (13, 23, 33, 43), der einen Komponentenanordnungsbereich enthält, in dem eine Vielzahl von Typen von Komponentengruppen angeordnet sind, und
einen einzelnen Montagekopf (14, 24), an dem mindestens eine oder mehrere Düsen angebracht sind und der die Vielzahl von Typen von Komponentengruppen, die von dem Komponentenzuführabschnitt (13, 23, 33, 43) zugeführt werden, auf die Leiterplatte (JOB) montiert, die in den Förderbahnen (11, 12, 21, 22) befördert wird, und
wobei das Leiterplattenherstellungsverfahren umfasst:
einen Bedingungsbestimmungsschritt zum Bestimmen einer Anordnung der Düsen in jedem der Montageköpfe (14, 24) und einer Anordnung der Vielzahl von Typen von Komponentengruppen in jedem der Komponentenzuführabschnitte (13, 23, 33, 43), so dass ein Zustand angenommen wird, in dem die Düsen, die an jedem der Montageköpfe (14, 24) angebracht sind, fixiert sind, d.h. die Düsen nicht ausgetauscht werden, während der kontinuierlichen Herstellung der Vielzahl von Typen von Leiterplatten (JOB), basierend auf einer Vielzahl von Typen von Komponentengruppen, die auf die Vielzahl von Typen von Leiterplatten (JOB) zu montieren sind, für welche die kontinuierliche Herstellung durchgeführt wird; und
einen Herstellungsschritt zum Durchführen einer kontinuierlichen Herstellung der Vielzahl von Typen von Leiterplatten (JOB) in der Anordnung jeder der Düsen und der Anordnung der Vielzahl von Typen von Komponentengruppen, die in dem Bedingungsbestimmungsschritt bestimmt werden,
wobei das Leiterplattenherstellungsverfahren kontinuierlich einen oder mehrere Typen einer ersten Leiterplatte (JOB) und einen oder mehrere Typen einer zweiten Leiterplatte (JOB) herstellt,
wobei der Bedingungsbestimmungsschritt beinhaltet:
einen ersten Bedingungsbestimmungsschritt zum Bestimmen der Anordnung der Düsen, die an jedem der Montageköpfe (14, 24) angebracht sind, und der Anordnung einer Vielzahl von Typen einer ersten Komponentengruppe in jedem der Komponentenzuführabschnitte (13, 23, 33, 43) basierend auf der Vielzahl von Typen der ersten Komponentengruppe, die auf der ersten Leiterplatte (JOB) montiert werden, und
einen zweiten Bedingungsbestimmungsschritt zum Bestimmen der Anordnung einer Vielzahl von Typen einer zweiten Komponentengruppe in jedem der Komponentenzuführabschnitte (13, 23, 33, 43) basierend auf der Vielzahl von Typen einer zweiten Komponentengruppe, die auf der zweiten Leiterplatte (JOB) zu montieren ist, unter Verwendung eines Zustands, in dem die Anordnung jeder der Düsen, die durch den ersten Bedingungsbestimmungsschritt bestimmt wird, als eine Zwangsbedingung festgelegt ist, und
wobei der Herstellungsschritt die kontinuierliche Herstellung der ersten Leiterplatte (JOB) und der zweiten Leiterplatte (JOB) in der Anordnung jeder der Düsen, die in dem ersten Bedingungsbestimmungsschritt bestimmt wird, die Anordnung der Vielzahl von Typen der ersten Komponentengruppe und die Anordnung der Vielzahl von Typen der zweiten Komponentengruppe, die in dem zweiten Bedingungsbestimmungsschritt bestimmt wird, durchführt,
wobei die erste Leiterplatte (JOB) eine Leiterplatte (JOB) eines Massenproduktionsprodukts ist, und
wobei die zweite Leiterplatte (JOB) eine Leiterplatte (JOB) eines in geringen Stückzahlen hergestellten Produkts ist, und
wobei der Komponentenzuführabschnitt (13, 23, 33, 43) nur auf einer Seite angeordnet ist, die nahe an einer ersten Förderbahn (11, 21) unter der Vielzahl von Förderbahnen (11, 12, 21, 22) liegt,
wobei die erste Förderbahn (11, 21) nur die Leiterplatte (JOB) des Massenproduktionsprodukts befördert, und
wobei die Leiterplatte (JOB) des in geringen Stückzahlen hergestellten Produkts nur in einer zweiten Förderbahn (12, 22) befördert wird, die auf einer Seite positioniert ist, die von dem Komponentenzuführabschnitt (13, 23, 33, 43) unter der Vielzahl von Förderbahnen (11, 12, 21, 22) weit entfernt ist.

2. Leiterplattenherstellungsverfahren nach Anspruch 1,
wobei der zweite Bedingungsbestimmungsschritt die Anordnung der Vielzahl von Typen der zweiten Komponentengruppe unter Verwendung eines zweiten Bereichs (D2, D3) bestimmt, der von einem ersten Bereich (D1) verschieden ist, in dem die Vielzahl von Typen der ersten Komponentengruppe in dem Komponentenanordnungsbereich angeordnet sind.

3. Leiterplattenherstellungsverfahren nach Anspruch 2,
wobei der zweite Bedingungsbestimmungsschritt die Anordnung der Vielzahl von Typen der zweiten Komponentengruppe unter Verwendung des zweiten Bereichs (D2, D3) für jeden Typ der zweiten Leiterplatte (JOB) bestimmt, und
wobei in dem zweiten Bereich (D2, D3) während der Herstellung der ersten Leiterplatte (JOB) ein Anordnungsänderungsprozess von der Vielzahl von Typen der zweiten Komponentengruppe, die auf der zweiten Leiterplatte (JOB) montiert werden, bei der es sich um ein vorheriges Produktionsziel handelt, zu der Vielzahl von Typen der zweiten Komponentengruppe, die auf der zweiten Leiterplatte (JOB) montiert werden, bei der es sich um ein nächstes Produktionsziel handelt, durchgeführt wird.

4. Leiterplattenherstellungsverfahren nach einem der vorhergehenden Ansprüche,
wobei in einem Fall, in dem die Herstellung der zweiten Leiterplatte (JOB) nicht möglich ist, wenn ein Zustand, in dem die Anordnung jeder der Düsen, die durch den ersten Bedingungsbestimmungsschritt bestimmt wird, feststeht, als eine Zwangsbedingung verwendet wird, der Bedingungsbestimmungsschritt einen dritten Bedingungsbestimmungsschritt zum Durchführen einer Neubestimmung der Anordnung der Düsen beinhaltet, die an jedem der Montageköpfe (14, 24) befestigt sind, und einer Bestimmung der Anordnung der Vielzahl von Typen der zweiten Komponentengruppe unter Verwendung eines Zustands, in dem die Anordnung der Vielzahl von Typen der ersten Komponentengruppe, die durch den ersten Bedingungsbestimmungsschritt bestimmt wird, als Zwangsbedingung festgelegt ist, und unter Verwendung einer Düse, die nicht in den Düsen enthalten ist, die im ersten Bedingungsbestimmungsschritt bestimmt werden und die gemeinsam für die Montage der zweiten Komponentengruppe und die Montage der ersten Komponentengruppe verwendet werden können.

## Revendications

1. Procédé de production de circuits pour mettre en œuvre la production en continu d'une pluralité de types de circuits imprimés (JOB) en utilisant une pluralité de machines de montage de composants (10, 20) qui sont disposées en série,
dans lequel chaque machine de la pluralité de machines de montage de composants (10, 20) comprend
une pluralité de voies de convoyage (11, 12, 21, 22) qui convoient la pluralité de types de circuits imprimés (JOB),
une section d'alimentation de composants (13, 23, 33, 43) qui comprend une région de disposition de composants dans laquelle est disposée une pluralité de types de groupes de composants, et
une tête de montage unique (14, 24) à laquelle sont attachées une ou plusieurs buses et qui monte la pluralité de types de groupes de composants qui sont alimentés par la section d'alimentation de composants (13, 23, 33, 43) sur le circuit imprimé (JOB) convoyé dans les voies de convoyage (11, 12, 21, 22), et
dans lequel le procédé de production de circuits comprend :
une étape de détermination de condition consistant à déterminer une disposition des buses dans chacune des têtes de montage (14, 24) et une disposition de la pluralité de types de groupes de composants dans chacune des sections d'alimentation de composants (13, 23, 33, 43) de telle sorte qu'un état est assumé dans lequel les buses qui sont attachées à chacune des têtes de montage (14, 24) sont fixes, c'est-à-dire dans lequel les buses ne sont pas échangées, durant la production en continu de la pluralité de types de circuits imprimés (JOB) sur base d'une pluralité de types de groupes de composants à monter sur la pluralité de types de circuits imprimés (JOB) pour lesquels la production en continu est mise en œuvre ; et
une étape de production consistant à mettre en œuvre une production en continu de la pluralité de types de circuits imprimés (JOB) dans la disposition de chacune des buses et la disposition de la pluralité de types de groupes de composants qui sont déterminées à l'étape de détermination de condition,
dans lequel le procédé de production de circuits produit en continu un ou plusieurs types d'un premier circuit imprimé (JOB) et un ou plusieurs types d'un deuxième circuit imprimé (JOB),
dans lequel l'étape de détermination de condition comprend
une première étape de détermination de condition consistant à déterminer la disposition des buses qui sont attachées à chacune des têtes de montage (14, 24) et la disposition d'une pluralité de types d'un premier groupe de composants dans chacune des sections d'alimentation de composants (13, 23, 33, 43) sur base de la pluralité de types du premier groupe de composants qui sont montés sur le premier circuit imprimé (JOB), et
une deuxième étape de détermination de condition consistant à déterminer la disposition d'une pluralité de types du deuxième groupe de composants dans chacune des sections d'alimentation de composants (13, 23, 33, 43) sur base de la pluralité de types du deuxième groupe de composants à monter sur le deuxième circuit imprimé (JOB) en utilisant un état dans lequel la disposition de chacune des buses qui est déterminée à la première étape de détermination de condition est fixe comme une condition de contrainte, et
dans lequel l'étape de production met en œuvre la production en continu du premier circuit imprimé (JOB) et du deuxième circuit imprimé (JOB) dans la disposition de chacune des buses qui est déterminée à la première étape de détermination de condition, la disposition de la pluralité de types du premier groupe de composants, et la disposition de la pluralité de types du deuxième groupe de composants qui est déterminée à la deuxième étape de détermination de condition,
dans lequel le premier circuit imprimé (JOB) est un circuit imprimé (JOB) d'un produit fabriqué en masse, et
dans lequel le deuxième circuit imprimé (JOB) est un circuit imprimé (JOB) d'un produit fabriqué en faible volume,
dans lequel la section d'alimentation de composants (13, 23, 33, 43) est disposée uniquement sur un côté proche d'une première voie de convoyage (11, 21) parmi la pluralité de voies de convoyage (11, 12, 21, 22),
dans lequel la première voie de convoyage (11, 21) convoie uniquement le circuit imprimé (JOB) du produit fabriqué en masse, et
dans lequel le circuit imprimé (JOB) du produit fabriqué en faible volume est convoyé uniquement dans une deuxième voie de convoyage (12, 22) qui est positionnée sur un côté éloigné de la section d'alimentation de composants (13, 23, 33, 43) parmi la pluralité de voies de convoyage (11, 12, 21, 22).

2. Procédé de production de circuits selon la revendication 1,
dans lequel la deuxième étape de détermination de condition détermine la disposition de la pluralité de types du deuxième groupe de composants en utilisant une deuxième région (D2, D3) autre qu'une première région (D1) dans laquelle les composants de la pluralité de types du premier groupe de composants sont disposés dans la région de disposition de composants.

3. Procédé de production de circuits selon la revendication 2,
dans lequel la deuxième étape de détermination de condition détermine la disposition de la pluralité de types du deuxième groupe de composants en utilisant la deuxième région (D2, D3) pour chaque type du deuxième circuit imprimé (JOB), et
dans lequel, dans la deuxième région (D2, D3), un processus de changement de disposition de la pluralité de types du deuxième groupe de composants qui sont montés sur le deuxième circuit imprimé (JOB), qui est une cible de production antérieure, à la pluralité de types du deuxième groupe de composants qui sont montés sur le deuxième circuit imprimé (JOB), qui est une cible de production suivante, est mis en œuvre durant la production du premier circuit imprimé (JOB).

4. Procédé de production de circuits selon l'une quelconque des revendications précédentes,
dans lequel, dans le cas où la production du deuxième circuit imprimé (JOB) n'est pas possible quand un état, dans lequel la disposition de chacune des buses qui est déterminée à la première étape de détermination de condition est fixe, est utilisé comme une condition de contrainte, l'étape de détermination de condition comprend une troisième étape de détermination de condition consistant à mettre en œuvre une redétermination de la disposition des buses qui sont attachées à chacune des têtes de montage (14, 24) et une détermination de la disposition de la pluralité de types du deuxième groupe de composants tout en utilisant un état dans lequel la disposition de la pluralité de types d'un premier groupe de composants qui sont déterminés à la première étape de détermination de condition est fixe comme une condition de contrainte, et l'utilisation d'une buse qui n'est pas incluse dans les buses qui sont déterminées à la première étape de détermination de condition et qui est utilisée communément pour le montage du deuxième groupe de composants et le montage du premier groupe de composants.
